# EUROPEAN PATENT SPECIFICATION

(11) **EP 3 252 892 B1**
(45) Date of publication and mention of the grant of the patent: **28.07.2021**
(21) Application number: 17170601.3
(22) Date of filing: 11.05.2017
(51) Int. Cl.: H02B 1/01, H02B 1/16, H02B 1/30, H02B 1/32, F16B 7/18

(54) **RAIL VEHICLE COMPRISING A CUBICLE**
SCHIENENFAHRZEUG MIT EINEM SCHRANK
VÉHICULE FERROVIAIRE ÉQUIPÉ D'UNE ARMOIRE

(30) Priority: 31.05.2016 GB 201609496
(43) Date of publication of application: 06.12.2017
(73) Proprietor: Bombardier Transportation GmbH, 10785 Berlin (DE)
(72) Inventor: Balmer-Bucher, Philipp, 8185 Winkel (CH); Winkler, Michael, 34497 Korbach (DE); Trautmann, Holger, 34121 Kassel (DE)
(74) Representative: Patentanwälte Bressel und Partner mbB

(56) References cited:
- EP-A1- 1 574 725
- EP-A1- 2 993 745
- EP-A2- 0 843 104
- WO-A1-01/61810
- WO-A1-2008/124910
- DE-A1- 19 948 329
- DE-A1-102011 006 744
- DE-A1-102012 206 321
- DE-U1- 29 817 470
- US-A- 5 695 263
- US-A1- 2012 218 065

## Description

The present invention relates to a cubicle and a rail vehicle wherein said cubicle is installed.

Electrical cubicles, hereinafter just cubicles, are used in railway vehicles as a cabinet for electrical or electronic equipment. The mechanical construction is the basis for all electrical cubicles. Therefore it is very important to get a concept which is globally feasible and stable. Welding always needs specialists, is expensive and needs long lead time. Premounted standard frames lead to a dependency to a specific supplier. Therefore there is a need for a flexible structure.

EP 2993745 A1 discloses a cubicle for a rail vehicle with the features of the preamble of claim 1. DE 102011006744 A1 dislcoses another cubicle for a rail vehicle. WO 2008124910 A1 and DE 29817470U disclose a cubicle with a frame made of profile rods. DE 19948329 A1 and WO 0161810 A1 disclose a cabinet with a mounting plate for electric devices mounted on profile rods of the cabinet frame. US 2012218065 A1 discloses an enclosure for electrical equipment comprising a frame and a mounting plate configured to support and ground a transformer. EP 1574725 A1 discloses a profile connection comprising two aluminium profile rods, a slot nut, a threaded sleeve and a screw.

The problem of the invention was to provide with a flexible structure for an electrical cubicle.

According to a basic idea of the invention, a framework of a cubicle is based on aluminium profiles that are interconnected. Building a framework for a cubicle with aluminium profiles provides with enhanced flexibility in construction. The profiles are fixed to each other in a detachable manner, preferably by screwed joints. This provides with the possibility to make modifications on a finished frame just by replacing or adding profiles. It is also possible to demount the frame for assembling and cabling electrical components inside the cubicle. This leads to more space which will make the process of cubicle and electric component assembly easier and faster. Profiles can be transported as single parts instead of a complete mounted framework which makes logistics easier and cheaper. Using a framework of aluminium-profiles has the following further advantage: different assembly blocks or assembly groups can be produced independently from each other and joined to form the final cubicle including its components. An assembly block may comprise parts of the framework and parts of electrical components of the cubicle. Working with such assembly blocks makes assembly of components easier in comparison to a method wherein in a first step a framework is formed and in a second step electrical components are placed in the framework. This will be further shown in examples. Finally the present invention provides with an easy way of grounding electrical components.

The present invention is defined by claim 1 and particularly provides with a rail vehicle comprising a cubicle, the cubicle comprising
- a framework comprising aluminium profile rods which are connected by detachable connections, wherein multiple of said connections are each reinforced by a stiffening member, wherein each stiffening member is fixed to the connected profile rods in the region of the connection,
- mounting plates which are fixed to the framework
- electrical components which are fixed to one or more of the mounting plates and which are located inside the framework.

The stiffening member is preferably a metal plate. The stiffening member may be screwed onto connected profile rods. Stiffening members serve to minimize load on connections, especially corner connections. Moreover, stiffening elements help in increasing resonance frequency of the framework.

Mounting plates are preferably made of metal.

In one embodiment one or more of the mounting plates have one or more groove-shaped recessions. Such groove-shaped recessions are also called reinforcing seam, stiffening corrugation, crimp or pleat. Groove-shaped recessions provide with following benefits: When electrical components are fixed to mounting plates the weight is increased locally which leads to vibrations. Groove-shaped recessions minimize or reduce such vibrations. Moreover, the recessions lead to a lower global resonance frequency and increased static stability.

According to the invention, at least one electrical component is electrically contacted to the mounting plate, and the mounting plate is electrically contacted to the framework, so that electrical grounding is provided if the framework is earthed. Several or all electrical components may be contacted, to the same or to different mounting plates. More than one of the mounting plates may be electrically contacted if electrical components are electrically contacted to different mounting plates. This embodiment provides with grounding of at least one of the electrical components or all electrical components via the mounting plate(s) and the framework. This embodiment is beneficial because fixation and electrical grounding is provided by the mounting plate(s). Moreover, the mounting plates have low electrical resistance, or can be chosen to have low electrical resistance, which facilitates electrical grounding. According to the invention, the connections between profile rods are conductive. Preferably, the whole framework is conductive without interruptions.

According to the invention, the profile rods are interconnected by conductive fastening means. This embodiment effects that conductivity between connective profile rods is provided.

In a further embodiment the mounting plates are fixed to the framework by conductive fastening means. This embodiment effects that electric conductivity between electric components, fixed to mounting plates and the framework is enabled.

Mentioned conductive fastening means are a conductive slot nut and a conductive screw.

Conductive means preferably fulfil standards for electrostatic discharge protection.

By using conductive fastening means for fixing profiles to each other and for fixing mounting plates to profiles electric conductivity within the cubicle is provided. Therefore, the framework may function as electric collecting pipe for grounding. The framework may be electrically connected with a vehicle body, the mounting plates may be electrically connected to the framework, particularly the profile rods, and the electrical components may be electrically connected to the mounting plates. So, grounding of all components can be ensured.

In one embodiment the profile rods comprise one or more T-slots. Such slots extend in longitudinal direction of the rods. In this embodiment later fitting of components at the framework is enabled with low effort.

The rail vehicle is preferably selected from following rail vehicles: Longs distance trains, near distance trains, suburban trains, subway-trains, streetcars.

According to the invention, the framework of the cubicle is grounded by electric connection to a vehicle body.

In a preferred embodiment the framework of the cubicle is fixed to a bottom of a rail vehicle or a bottom of a vehicle body. Grounding can be effected though the bottom, where the framework is fixed and mechanically stabilized. Alternatively, grounding can be effected at another place, for example through a wall.

Hereinafter the present invention is described with reference to working examples.

### Brief description of Figures:

- Fig. 1: a cubicle of the invention;
- Fig. 2: a perspective view on the framework of a cubicle of Fig. 1;
- Fig. 3: a view from the bottom into the interior of a cubicle;
- Fig. 4: a perspective view on a cubicle from another side;
- Fig. 5: a method of assembly of a cubicle;
- Fig. 6: fastening means that are suitable for connecting aluminium profile rods;
- Fig. 7: a rail vehicle with a cubicle.

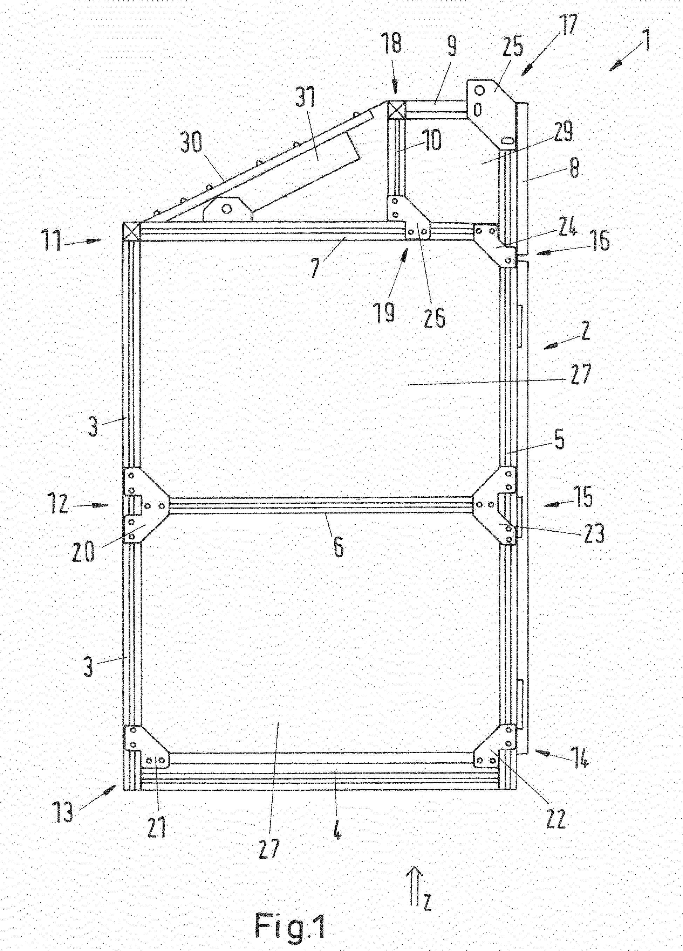

Fig. 1 shows a cubicle 1 of the invention. The cubicle comprises the framework 2. The framework 2 comprises aluminium profile rods 3, 4, 5, 6, 7, 8, 9, 10. Connections between the rods 3 - 10 are shown at positions 11, 12 and 13, 14, 15, 16, 17, 18, 19.

Connection 12 is reinforced by a stiffening member, which is a metal plate, 20. The metal plate 20 is fixed to profile rods 3 and 6. Fixation is done by screws. Connection 13 is in the same manner reinforced by stiffening member 21, connection 14 by a stiffening member 22, connection 15 by a stiffening member 23, connection 16 by a stiffening member 24, connection 17 by a stiffening member 25 and connection 19 by a stiffening member 26.

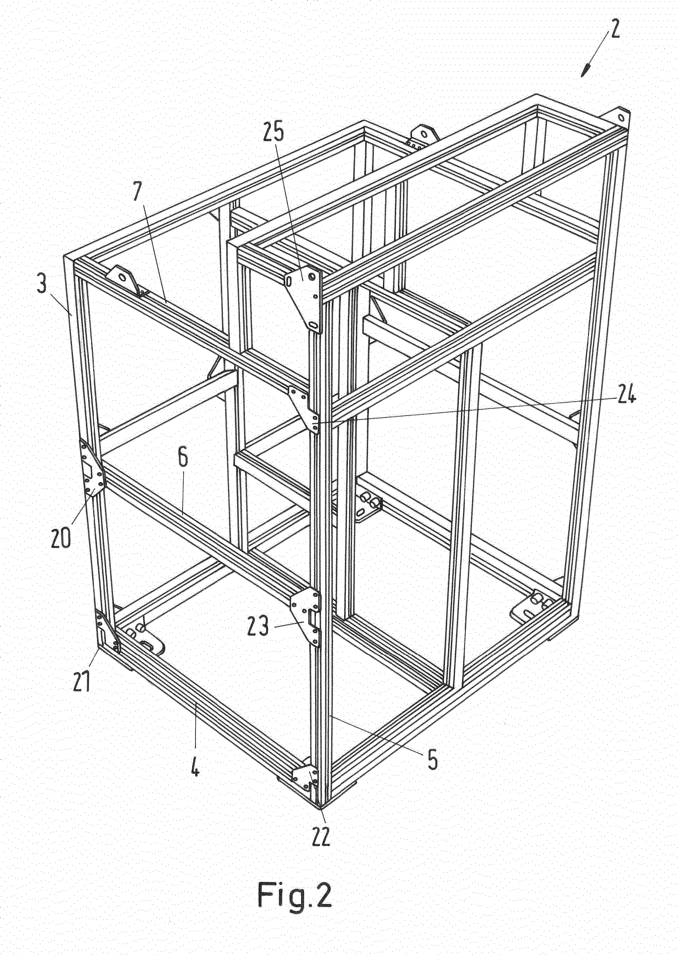

Fig. 2 is a perspective view on the framework 2 of Fig. 1 only. Further aluminium profile rods and connections and stiffening members are shown. Selected features are designated with the same reference numbers as in Fig. 1.

Fig. 1 moreover shows mounting plates 27, 29, 30 which are fixed to the framework 2. As can be seen from Fig. 1, the mounting plates are fixed to an internal side of the profile rods 3 - 10, because Fig. 1 shows the outer side of the cubicle 1 and the observer first seas the profile rods and then the mounting plates 27 - 30, which are located behind the profile rods. Shown is mounting plate 31 for plugs to realise the electrical connection to a cable duct on the sidewall inside a locomotive.

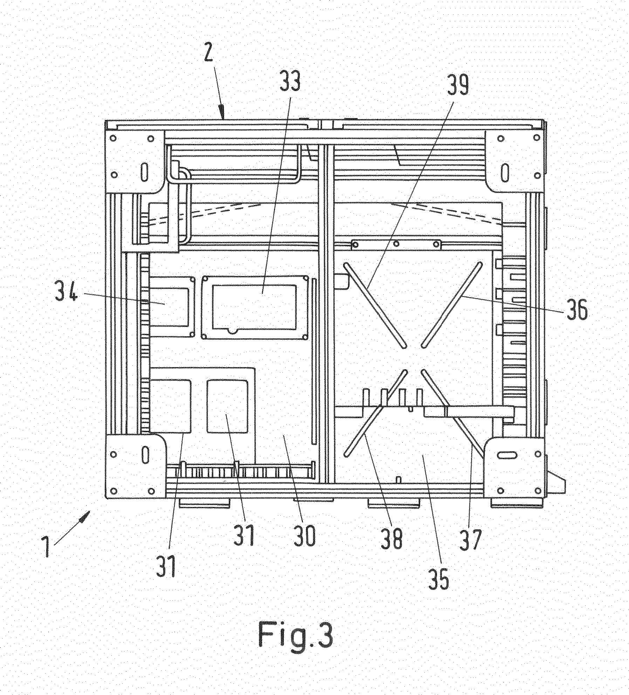

Fig. 3 shows a view from the bottom (direction in arrow Z in Fig. 1) into the interior of the cubicle 1. Shown are mounting plates 31, 33 and 34 for plugs to realise the electrical connection to a cable duct on the sidewall inside the locomotive.

A further mounting plate 35 is shown which has four groove-shaped recessions 36, 37, 38, 39.

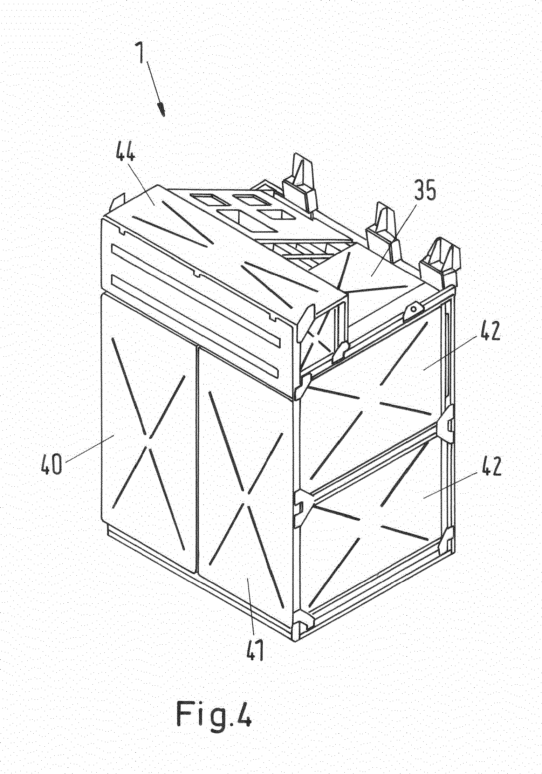

Fig. 4 shows a perspective view on the cubicle 1 from another side. Further mounting plates 40, 41, 42, 44 are shown wherein each of these mounting plates also has several groove-shaped recessions, as mounting plate 35 in Fig. 3. On each of said mounting plates 40, 41, 42, 44 groove-shaped recessions are arranged in an X-type arrangement but not designated with reference symbols.

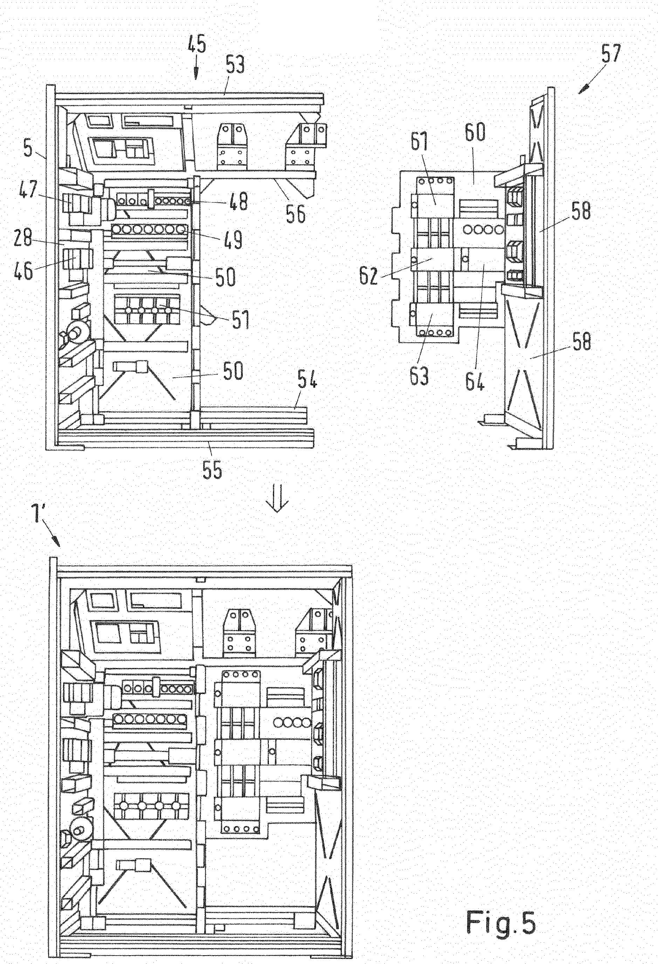

Fig. 5 shows a method of assembly of a cubicle 1. A first assembly block 45 is formed. First, electrical components 46 and 47 are assembled on mounting plate 27 and electrical components 48 and 49 are fixed to mounting plate 50 and electrical component 51 is also fixed to mounting plate 50. Only some of the electrical components are shown or designated with reference numbers. Further electrical components can be present. Moreover mechanical components can be fixed to mounting plates. Then, mounting plates 50, 27 with the electrical components fixed thereon are fixed to aluminium profile rods. Aluminium profile rods 5, 53, 54, 55 are designated with reference numbers. Before mounting plates are fixed, profile rods are connected to each other to form a part of the framework 2, which is shown in Fig. 5 in assembly block 45.

In the same manner, a second assembly block 57 is pre-formed. Assembly block 57 comprises mounting plates 58, 60 and electrical components 61, 62, 63, 64.

When both assembly blocks 45 and 57 are fixed to each other, an intermediate product 1' of the cubicle 1 of Fig. 1 is obtained. Further method steps can be performed, like mounting of central aluminium profile rods, mounting heavy or balky devices/operators, mounting further preassembled electrical components, finish the remaining cabling and mounting the remaining doors and covers.

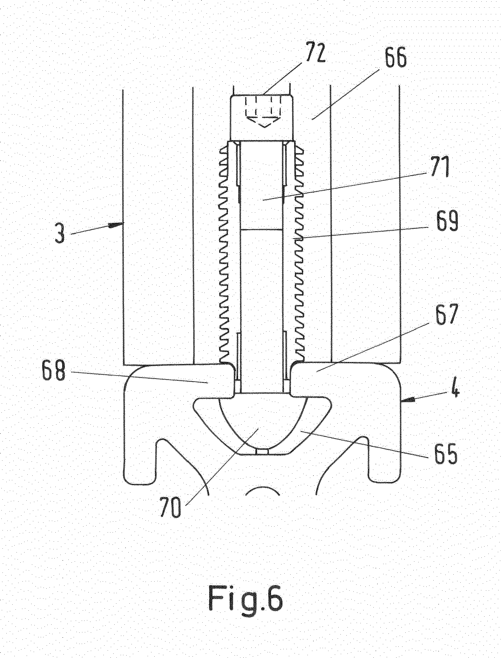

Fig. 6 shows fastening means that are suitable for connecting aluminium profile rods or that are also suitable for connecting mounting plates with aluminium profile rods. Fig. 6 shows a first profile rod 3 and a part of a second profile rod 4. Profile rod 3 is shown in longitudinal direction. Profile rod 4 is shown in a cross section.

Profile rod 4 comprises a T-slot 65. Profile rod 3 also comprises a T-slot 66 which is cut open in this figure, i.e. flanks 67, 68 of a T-slot are not shown in T-slot 66. A screw collar 69 is screwed into the T-slot 66. A slot nut 70 is inserted into the T-slot 65 of profile rod 4. A screw 71 is inserted into the screw collar 69 and fits with its head 72 at the end of the screw collar 69. When the screw 71 is turned, it is screwed into the slot nut 70 which presses against the flanks 67, 68. In result, both profile rods 3, 4 are pressed and fixed against each other.

The fastening means 69, 70, 71, 72 in Fig. 6 are conductive for electric current so that current can flow from profile rod 3 to 4 or from 4 to 3. If mounting plates which were shown before are also made from a metal, electric current can flow from electrical components to a mounting plate and from a mounting plate to the profile rods where the mounting plate is fixed. Conductive fastening means enable current flow within the framework 2.

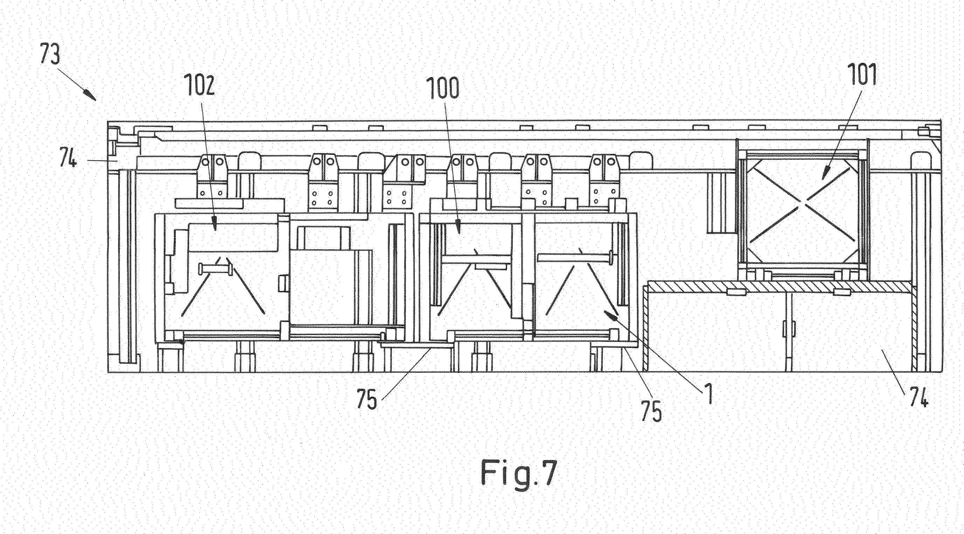

Fig. 7 shows a rail vehicle 73 with the vehicle body 74. The cubicle 1 is fixed to supporting structures 75 which are part of the vehicle body 74. Further cubicles 101, 102 are fixed in the vehicle body 74. The framework 2 of the cubicle 1 is electrically connected to the vehicle body 74, as it is the case with the frameworks of cubicles 101, 102.

### List of reference numbers

- 1: Cubicle
- 2: Framework
- 3: Aluminium profile rod
- 4: Aluminium profile rod
- 5: Aluminium profile rod
- 6: Aluminium profile rod
- 7: Aluminium profile rod
- 8: Aluminium profile rod
- 9: Aluminium profile rod
- 10: Aluminium profile rod
- 11: Detachable connection
- 12: Detachable connection
- 13: Detachable connection
- 14: Detachable connection
- 15: Detachable connection
- 16: Detachable connection
- 17: Detachable connection
- 18: Detachable connection
- 19: Detachable connection
- 20: Stiffening member
- 21: Stiffening member
- 22: Stiffening member
- 23: Stiffening member
- 24: Stiffening member
- 25: Stiffening member
- 26: Stiffening member
- 27: Mounting plate
- 29: Mounting plate
- 30: Mounting plate
- 31: mounting plate for plug
- 33: mounting plate for plug
- 34: mounting plate for plug
- 35: Mounting plate
- 36: Groove-shaped recession
- 37: Groove-shaped recession
- 38: Groove-shaped recession
- 39: Groove-shaped recession
- 40: Mounting plate
- 41: Mounting plate
- 42: Mounting plate
- 44: Mounting plate
- 45: First assembly block
- 46: Electrical component
- 47: Electrical component
- 48: Electrical component
- 49: Electrical component
- 50: Mounting plate
- 51: Electrical component
- 53: Aluminium profile rod
- 54: Aluminium profile rod
- 55: Aluminium profile rod
- 56: Aluminium profile rod
- 57: Second assembly block
- 58: Mounting plate
- 60: Mounting plate
- 61: Electrical component
- 62: Electrical component
- 63: Electrical component
- 64: Electrical component
- 65: T-slot
- 66: T-slot
- 67: flank
- 68: flank
- 69: Fastening means - screw collar
- 70: Fastening means - conductive slot nut
- 71: Fastening means - conductive screw
- 72: Fastening means - screw head
- 73: Rail vehicle
- 74: Vehicle body

## Claims

1. Rail vehicle (73), comprising a cubicle (1), the cubicle comprising
- a framework (2) comprising aluminium profile rods (3, 4, 5, 6, 7, 8, 9, 10, 53, 54, 55, 56) which are connected by connections (11, 12, 13, 14, 15, 16, 17, 18, 19), wherein multiple of said connections are each reinforced by a stiffening member (20, 21, 22, 23, 24, 25, 26), wherein each stiffening member is fixed to the connected profile rods in the region of the connection, wherein
- the framework (2) is grounded by electric connection to a vehicle body (74) **characterized in that**
- the cubicle further comprises mounting plates (27, 29, 30, 35, 40, 41, 42, 44, 50, 58, 60) which are fixed to the framework (2) and electrical components (46, 47, 48, 49, 51) which are fixed to one or more of the mounting plates and which are located inside the framework (2)
- at least one electrical component (46, 47, 48, 49, 51) is electrically contacted to one of the mounting plates (27, 29, 30, 35, 40, 41, 42, 44, 50, 58, 60), and the mounting plate is electrically contacted to the framework (2), so that electrical grounding is provided if the framework (2) is earthed,
- the connections are detachable connections, which directly interconnect the profile rods (3, 4, 5, 6, 7, 8, 9, 10, 53, 54, 55, 56) by conductive fastening means (69, 70, 71, 72), the conductive fastening means (69, 70, 71, 72) comprising a combination of a conductive slot nut (70) and a conductive screw (71).

2. Rail vehicle (73) according to claim 1, wherein one or more of the mounting plates (27, 29, 30, 35, 40, 41, 42, 44, 50, 58, 60) have one or more groove-shaped recessions (36, 37, 38, 39).

3. Rail vehicle (73) according to one or more of the preceding claims, wherein the mounting plates are fixed to the framework (2) by conductive fastening means (69, 70, 71, 72).

4. Rail vehicle (73) according to one or more of the preceding claims, wherein one or more profile rods (3, 4, 5, 6, 7, 8, 9, 10, 53, 54, 55, 56) each comprise one or more T-slots (65, 66).

5. Rail vehicle (73) according to one or more of the preceding claims, wherein the stiffening member (20, 21, 22, 23, 24, 25, 26) is a metal plate.

## Patentansprüche

1. Schienenfahrzeug (73), umfassend einen Schrank (1), wobei der Schrank umfasst:
- eine Rahmenkonstruktion (2), umfassend Aluminiumprofilstäbe (3, 4, 5, 6, 7, 8, 9, 10, 53, 54, 55, 56), die durch Verbindungen (11, 12, 13, 14, 15, 16, 17, 18, 19) verbunden sind,
wobei mehrere der Verbindungen jeweils durch ein Versteifungselement (20, 21, 22, 23, 24, 25, 26) verstärkt sind, wobei jedes Versteifungselement an den verbundenen Profilstäben in der Region der Verbindung befestigt ist,
wobei
- die Rahmenkonstruktion (2) durch elektrische Verbindung an einen Fahrzeugwagenkasten (74) geerdet ist,
**dadurch gekennzeichnet, dass**
- der Schrank ferner Montageplatten (27, 29, 30, 35, 40, 41, 42, 44, 50, 58, 60) umfasst, die an der Rahmenkonstruktion (2) befestigt sind, und elektrische Komponenten (46, 47, 48, 49, 51), die an der einen oder mehreren der Montageplatten befestigt sind und die sich in der Rahmenkonstruktion (2) befinden,
- sich mindestens eine elektrische Komponente (46, 47, 48, 49, 51) in elektrischem Kontakt mit einer der Montageplatten (27, 29, 30, 35, 40, 41,42, 44, 50, 58, 60) befindet, und die Montageplatte sich in elektrischem Kontakt mit der Rahmenkonstruktion (2) befindet, sodass elektrische Erdung bereitgestellt ist, wenn die Rahmenkonstruktion (2) geerdet ist,
- die Verbindungen lösbare Verbindungen sind, die die Profilstäbe (3, 4, 5, 6, 7, 8, 9, 10, 53, 54, 55, 56) durch leitfähige Befestigungsmittel (69, 70, 71, 72) direkt verbinden, wobei die leitfähigen Befestigungsmittel (69, 70, 71, 72) eine Kombination aus einem leitfähigen Nutenstein (70) und einer leitfähigen Schraube (71) umfassen.

2. Schienenfahrzeug (73) nach Anspruch 1, wobei eine oder mehrere der Montageplatten (27, 29, 30, 35, 40, 41, 42, 44, 50, 58, 60) eine oder mehrere nutförmige Vertiefungen (36, 37, 38, 39) aufweist.

3. Schienenfahrzeug (73) nach einem oder mehreren der vorangehenden Ansprüche, wobei die Montageplatten durch leitfähige Befestigungsmittel (69, 70, 71, 72) an der Rahmenkonstruktion (2) befestigt sind.

4. Schienenfahrzeug (73) nach einem oder mehreren der vorangehenden Ansprüche, wobei ein oder mehrere Profilstäbe (3, 4, 5, 6, 7, 8, 9, 10, 53, 54, 55, 56) jeweils einen oder mehrere T-Schlitze (65, 66) umfassen.

5. Schienenfahrzeug (73) nach einem oder mehreren der vorangehenden Ansprüche, wobei das Versteifungselement (20, 21, 22, 23, 24, 25, 26) eine Metallplatte ist.

## Revendications

1. Véhicule ferroviaire (73), comprenant une armoire (1), l'armoire comprenant
- un châssis (2) comprenant des barres profilées en aluminium (3, 4, 5, 6, 7, 8, 9, 10, 53, 54, 55, 56) qui sont raccordées par des raccords (11, 12, 13, 14, 15, 16, 17, 18, 19), dans lequel une multitude desdits raccords sont renforcés chacun par un organe de raidissement (20, 21, 22, 23, 24, 25, 26), dans lequel chaque organe de raidissement est fixé aux barres profilées raccordées dans la région du raccord,
dans lequel
- le châssis (2) est mis à la masse par un raccordement électrique à une carrosserie de véhicule (74) **caractérisé en ce que**
- l'armoire comprend en outre des plaques de montage (27, 29, 30, 35, 40, 41, 42, 44, 50, 58, 60) qui sont fixées au châssis (2) et des composants électriques (46, 47, 48, 49, 51) qui sont fixés à une ou plusieurs des plaques de montage et qui sont situés à l'intérieur du châssis (2)
- au moins un composant électrique (46, 47, 48, 49, 51) est mis en contact électrique avec l'une des plaques de montage (27, 29, 30, 35, 40, 41, 42, 44, 50, 58, 60), et la plaque de montage est mise en contact électrique avec le châssis (2), de façon à assurer une mise électrique à la terre si le châssis (2) est relié à la terre,
- les raccords sont des raccords détachables, qui relient directement les barres profilées (3, 4, 5, 6, 7, 8, 9, 10, 53, 54, 55, 56) par des moyens d'arrimage conducteurs (69, 70, 71, 72), les moyens d'arrimage conducteurs (69, 70, 71, 72) comprenant une combinaison d'un écrou à fente conducteur (70) et d'une vis conductrice (71).

2. Véhicule ferroviaire (73) selon la revendication 1, dans lequel une ou plusieurs des plaques de montage (27, 29, 30, 35, 40, 41, 42, 44, 50, 58, 60) ont un ou plusieurs renfoncements en forme de rainure (36, 37, 38, 39).

3. Véhicule ferroviaire (73) selon l'une ou plusieurs des revendications précédentes, dans lequel les plaques de montage sont fixées au châssis (2) par des moyens d'arrimage conducteurs (69, 70, 71, 72).

4. Véhicule ferroviaire (73) selon l'une ou plusieurs des revendications précédentes, dans lequel une ou plusieurs barres profilées (3, 4, 5, 6, 7, 8, 9, 10, 53, 54, 55, 56) comprennent chacune une ou plusieurs ouvertures rectangulaires (65, 66).

5. Véhicule ferroviaire (73) selon l'une ou plusieurs des revendications précédentes, dans lequel l'organe de raidissement (20, 21, 22, 23, 24, 25, 26) est une plaque en métal.
